# EUROPEAN PATENT APPLICATION

(11) **EP 3 696 908 A1**
(43) Date of publication of application: **19.08.2020**
(21) Application number: 19157715.4
(22) Date of filing: 18.02.2019
(51) Int. Cl.: H01Q 1/02, H05K 7/20, H01Q 1/12, H01Q 1/24

(54) **MOUNTING DEVICE FOR AN ACTIVE ELECTRONIC MODULE**

(71) Applicant: Nokia Shanghai Bell Co., Ltd., Shanghai 201206 (CN)
(72) Inventor: Harel, Jean-Pierre, 22300 Lannion (FR); Julien, Thomas, 22300 LANNION (FR)
(74) Representative: DREISS Patentanwälte PartG mbB

(57) **Abstract**

Mounting device for mounting at least one active electronic module to a structure, wherein said mounting device comprises a non-planar mounting surface to which said electronic module can be mounted, and at least one heatsink to transfer thermal energy from said mounting device to a surrounding medium.

## Description

### Field of the invention

Exemplary embodiments relate to a mounting device for mounting at least one active electronic module to a structure.

### Background

Mounting devices may be used to mount one or more modules to a structure.

### Summary

Exemplary embodiments relate to a mounting device for mounting at least one active electronic module to a structure, wherein said mounting device comprises a non-planar mounting surface to which said electronic module can be mounted, and at least one heatsink configured to transfer thermal energy from said mounting device to a surrounding medium. This advantageously enables to control a temperature of said at least one active electronic module, particular enabling an efficient cooling of said at least one active electronic module.

According to further exemplary embodiments, said active electronic module does not comprise an own heatsink. Rather, a substantial amount of thermal energy dissipated by said active electronic module may be transferred to the mounting device according to the embodiments by means of said mounting surface of the mounting device. In these embodiments, the electronic module may comprise a particularly lightweight design as no heatsink is required to be provided at the module itself.

According to further exemplary embodiments, said active electronic module may comprise an own heatsink. In these cases, too, a substantial amount of thermal energy dissipated by said active electronic module may be transferred to the mounting device according to the embodiments via said mounting surface.

According to further exemplary embodiments, said active electronic module comprises at least one active electronic element which at least in some operational states may dissipate heat when being supplied with electrical energy, and which may e.g. comprise at least one of: a radio device, e.g., an active antenna (AA) module, a active-passive antenna (APA) module, an amplifier, particularly for radio frequency, RF, signals, (massive) MIMO (multi-input multi-output) antenna panel.

According to further exemplary embodiments, said mounting surface of the mounting device enables a transfer of thermal energy from said electronic module to said mounting device.

According to further exemplary embodiments, said mounting surface comprises corrugations, which advantageously increases an effective surface for enabling a transfer of heat energy from the electronic module to said mounting device.

According to further exemplary embodiments, at least some of said corrugations have a cross-section which is at least partly polygonal, particularly trapezoidal, or sinusoidal. According to further exemplary embodiments, the electronic module may comprise a contact surface that comprises a shape which is complementary to the mounting surface, e.g. the corrugations, to optimize a transfer of heat energy.

According to further exemplary embodiments, said mounting surface is configured to form at least one of: a) a dovetail joint, and/or b) a mortise and tenon joint with a contact surface of said electronic module. According to further exemplary embodiments, other low mechanical tolerance fixture designs are also possible.

According to further exemplary embodiments, an actual surface of said mounting surface is larger than a projection of said mounting surface to any arbitrary virtual plane.

According to further exemplary embodiments, said mounting device comprises a main body and at least one mounting element that comprises said mounting surface.

According to further exemplary embodiments, said at least one mounting element is movably attached to said main body, which may facilitate installation of an electronic module to said mounting element.

According to further exemplary embodiments, more than one mounting element may be provided, and one or more of said mounting elements may be movably attached to said main body.

According to further exemplary embodiments, said mounting device comprises at least one sliding rail that connects said at least one mounting element to said main body.

According to further exemplary embodiments, at least a part of said mounting surface has a surface roughness of 6.3 µm (micrometer) or less, e.g. about 0.8 µm.

According to further exemplary embodiments, said mounting surface has a thermal conductance of about 200 to about 300 W/m*K (watts per meter kelvin).

Further exemplary embodiments relate to a system comprising a mounting device according to the embodiments and at least one active electronic module, wherein said active electronic module has a contact surface for attachment to said non-planar mounting surface of said mounting device, wherein said contact surface comprises a shape which is complementary to said non-planar mounting surface.

Further exemplary embodiments relate to a use of at least one mounting device according to the embodiments for a) mounting at least one active electronic module to a structure and/or for b) cooling said at least one active electronic module, wherein preferably the mounting element advantageously enables simultaneous mounting and cooling of said at least one active electronic module.

Further exemplary embodiments relate to an active electronic module for use with a mounting device according to the embodiments, wherein said electronic module comprises a non-planar contact surface configured to make thermally conductive contact with said non-planar mounting surface of said mounting device.

### Brief description of the figures

Some exemplary embodiments will now be described with reference to the accompanying drawings.
- Fig. 1A: schematically depicts a side view of a mounting device according to exemplary embodiments in a first state,
- Fig. 1B: schematically depicts a side view of the mounting device of Fig. 1A in a second state,
- Fig. 1C: schematically depicts a bottom view of the mounting device of Fig. 1B,
- Fig. 2: schematically depicts a bottom view of mounting device according to further exemplary embodiments,
- Fig. 3A: schematically depicts a side view of a mounting device according to further exemplary embodiments in a first state,
- Fig. 3B: schematically depicts a perspective view of the mounting device of Fig. 3A in said first state,
- Fig. 3C: schematically depicts a perspective view of the mounting device of Fig. 3A in a second state,
- Fig. 4A: schematically depicts a front view of a mounting device according to further exemplary embodiments in a first state,
- Fig. 4B: schematically depicts a front view of the mounting device of Fig. 4A in a second state,
- Fig. 5A: schematically depicts a perspective view of the mounting device of Fig. 4A,
- Fig. 5B: schematically depicts details of Fig. 5A, and
- Fig. 6: schematically depicts a perspective view of a mounting device according to further exemplary embodiments.

### Description of the embodiments

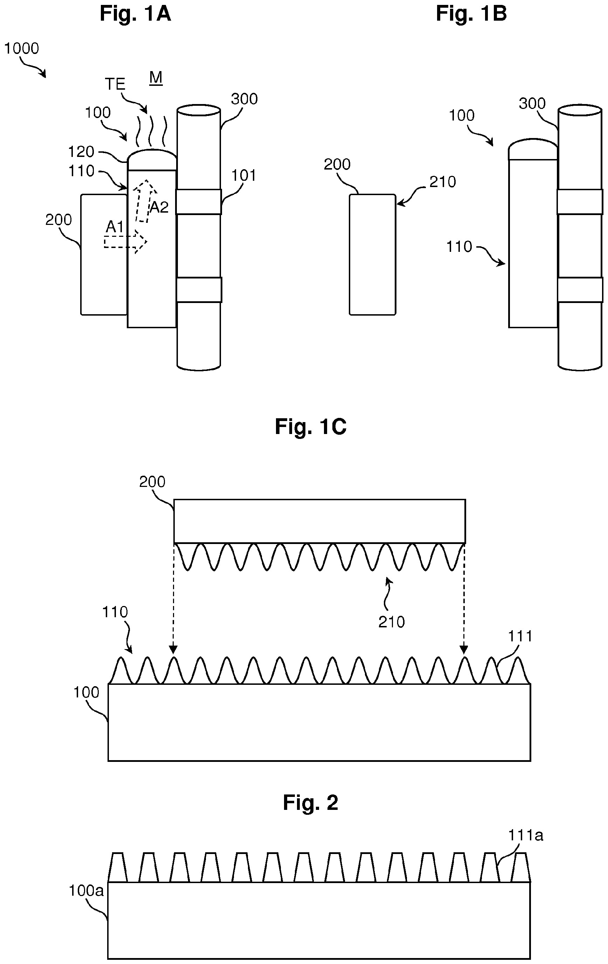

Figure 1A schematically depicts a side view of a mounting device 100 according to exemplary embodiments in a first state, wherein an active electronic module 200 is attached to said mounting device 100. Figure 1B schematically depicts a side view of said mounting device 100 of Fig. 1A in a second state, wherein said electronic module 200 is detached from said mounting device 100.

According to exemplary embodiments, said mounting device 100 is used for mounting at least one active electronic module 200 to a structure 300, such as a building or an antenna mast or the like. Said mounting device 100 comprises a non-planar mounting surface 110 to which said electronic module 200 can be mounted, and at least one heatsink 120 configured to transfer thermal energy TE from said mounting device 100 to a surrounding medium M, e.g. air. This advantageously enables to control a temperature of said at least one active electronic module 200, particular enabling an efficient cooling of said at least one active electronic module 200.

An exemplary flow of thermal energy from said electronic module 200 to said mounting device 100 according to further exemplary embodiments is symbolized by block arrow A1 of Fig. 1A, and an exemplary flow of thermal energy from said mounting device 100 to said heatsink 120 and the surrounding medium M, is symbolized by block arrow A2 and elements denoted with reference sign TE of Fig. 1A.

According to further exemplary embodiments, said mounting device 100 comprises a at least one fixing device 101 for securing said mounting device 100 (together with the attached electronic module 200, cf. Fig. 1A) to the structure 300, i.e. antenna mast 300.

According to further exemplary embodiments, due to the non-planar mounting surface 110, a particularly efficient transfer of heat energy from said electronic module 200 to said mounting device 100 is enabled via a non-planar contact surface 210 (Fig. 1B) of said electronic module 200, which is particularly complementary in shape with respect to the non-planar mounting surface 110 of the mounting device.

According to further exemplary embodiments, said active electronic module 200 does not comprise an own heatsink. Rather, a substantial amount of thermal energy dissipated by said active electronic module 200 may be transferred to the mounting device 100 according to the embodiments by means of said mounting surface 110 of the mounting device 100. In these embodiments, the electronic module 200 may comprise a particularly lightweight design as no heatsink is required to be provided at the module 200 itself, which facilitates mounting of said module 200 to the structure 300.

According to further exemplary embodiments, said active electronic module 200 may comprise an own heatsink (not shown). In these cases, too, a substantial amount of thermal energy dissipated by said active electronic module 200 may be transferred to the mounting device 100 according to the embodiments via said mounting surface 110.

According to further exemplary embodiments, said active electronic module 200 comprises at least one active electronic element (not shown) which at least in some operational states may dissipate heat when being supplied with electrical energy, and which may e.g. comprise at least one of: a radio device, e.g., an active antenna (AA) module, a active-passive antenna (APA) module, an amplifier, particularly for radio frequency, RF, signals, (massive) MIMO (multi-input multi-output) antenna panel.

According to further exemplary embodiments, said mounting surface 110 comprises corrugations 111, cf. the schematic bottom view of Fig. 1C (where the module 200 is detached from the mounting surface 110), which advantageously increases an effective surface for enabling a transfer of heat energy from the electronic module 200 to said mounting device 100.

According to further exemplary embodiments, at least some of said corrugations 111 have a cross-section which is sinusoidal or at least basically sinusoidal or similar to a sinusoidal shape.

According to further exemplary embodiments 100a, cf. the bottom view of Fig. 2, at least some of said corrugations 111a of the mounting device 100a have a cross-section which is at least partly polygonal, particularly trapezoidal.

According to further exemplary embodiments, the electronic module 200 may comprise a contact surface 210 (Fig. 1C) that comprises a shape which is complementary to the (shape of the) mounting surface 110, e.g. the corrugations 111, 111a, to optimize a transfer of heat energy.

According to further exemplary embodiments, an actual surface of said mounting surface 110 is larger than a projection of said mounting surface to any arbitrary virtual plane, which virtual plane may comprise an arbitrary spatial orientation with respect to said mounting surface. E.g., when considering a front view (not shown) of the mounting surface 110, which may exemplarily have a basically rectangular contour with a width W and a height H, a projection of said mounting surface 110 in the sense of said front view would correspond in size to an area A of A = W * H, whereas due to said non-planar shape, e.g. the corrugations 111, an actual surface that may actively be used for heat transfer between elements 200, 100 may, according to further exemplary embodiments, be considerably greater than said area A.

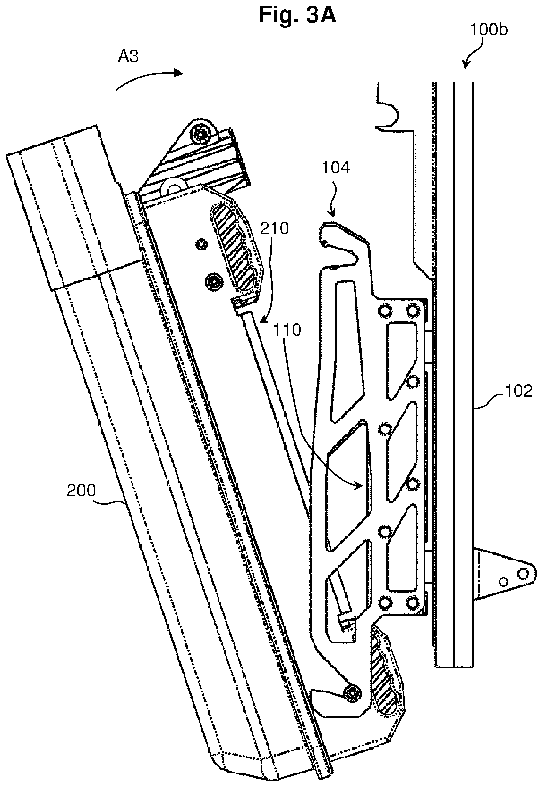

According to further exemplary embodiments, cf. the side view of Fig. 3A, said mounting device 100b comprises a main body 102 and at least one mounting element 104 that comprises said mounting surface 110 (note that the non-planar surface structure of the mounting surface 110 covered by the mounting element 104 in Fig. 3A). In the configuration 100b of Fig. 3A, the corrugations 111 (Fig. 1C) of the mounting surface 110 are exemplarily extending to the left, i.e. towards a preferably complementarily shaped contact surface 210 of the module 200. By rotating, cf. block arrow A3, the module 200, it may be engaged with the mounting element 104, so that the non-planar heat transfer surfaces 210, 110 make good thermal contact with each other. In the first state depicted by Fig. 3A, the module 200 is not yet fully attached to the mounting element 100.

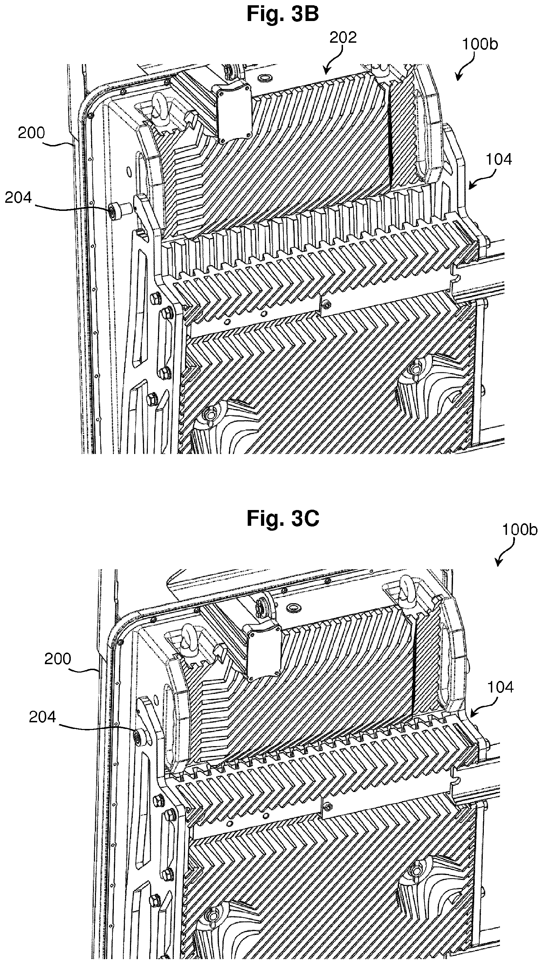

Figure 3B schematically depicts a perspective view of the mounting device 100b of Fig. 3A in said first state. In this view, the interlacing corrugations of the surfaces 210, 110 can be seen. According to further exemplary embodiments, the module 200 may comprise an own heatsink 202 to further improve cooling.

Figure 3C schematically depicts a perspective view of the mounting device 100b of Fig. 3A in a second state, where the module 200 is fully attached to the mounting element 104 and where the non-planar (presently trapezoidally corrugated) heat transfer surfaces 210, 110 make good thermal contact with each other. According to further exemplary embodiments, the module 200 may be secured to said mounting element 104 by means of screws 204.

According to further exemplary embodiments, said at least one mounting element 104 is movably attached to said main body 102, which may facilitate installation of an electronic module to said mounting element.

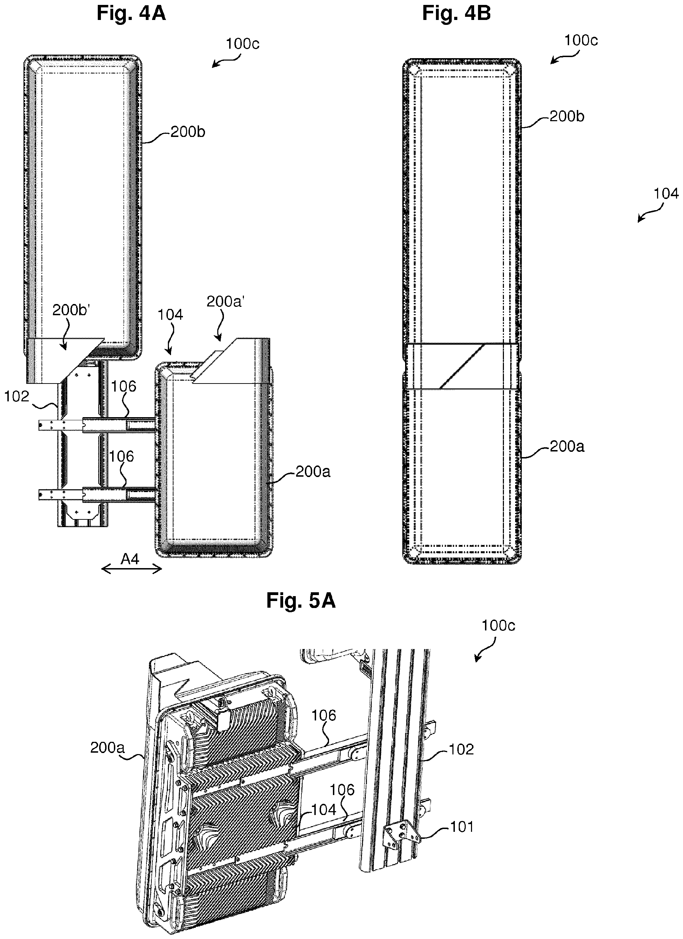

In this respect, Figure 4A schematically depicts a front view of a mounting device 100c according to further exemplary embodiments in a first state, and Figure 4B schematically depicts a front view of said mounting device 100c of Fig. 4A in a second state.

Presently, said mounting device 100c comprises at least one sliding rail 106 (two sliding rails 106 are exemplarily depicted by Fig. 4A, 4B) that - presently horizontally slidably, cf. double arrow A4, connects said at least one mounting element 104 to said main body 102. This way, the mounting element 104 may be slided to the right position as exemplarily depicted by Fig. 4A, representing said first state, wherein the first module 200a may e.g. be efficiently attached to said mounting element 104. After attaching (and optionally securing) said first module 200a to said mounting element 104, the mounting element 104 may be slid to the left, whereby the second state as exemplarily depicted by Fig. 4B is attained.

Presently, one further (active) module 200b is also attached to the mounting device 100c. According to further exemplary embodiments, the module 200a may be an active passive antenna (APA) module, and the module 200b may be a fully passive antenna module.

According to further exemplary embodiments, said further module 200b may be similarly attached to the main body 102, i.e. using a mounting element with sliding rail(s) 106 (not shown). According to further exemplary embodiments, said further module 200b may be directly attached to the main body 102 and/or to a further mounting element (not shown) with a non-planar mounting surface 110 (Fig. 1A) for optimized heat transfer.

According to further exemplary embodiments at least one of said modules 200a, 200b may comprise respective connectors 200a', 200b', e.g. electrical (and/or electro-optical or other types of hybrid) connectors (e.g., blind mate connectors, especially blind mate RF connectors) in opposing axial end sections of said modules 200a, 200b such that they may be mated by the sliding action of mounting element 104 as explained above with reference to Fig. 4A.

Figure 5A schematically depicts a perspective view of the mounting device 100c of Fig. 4A, wherein details of the mounting element 104 and its connection with the sliding rails 106 can be seen. Also depicted is a fixing device 101 for fixing said main body 102 to a structure 300 (Fig. 1A).

According to further exemplary embodiments, more than one mounting element 104 (Fig. 4A) may be provided, and one or more of said mounting elements (not shown) may be movably attached to said main body 102 (Fig. 4A).

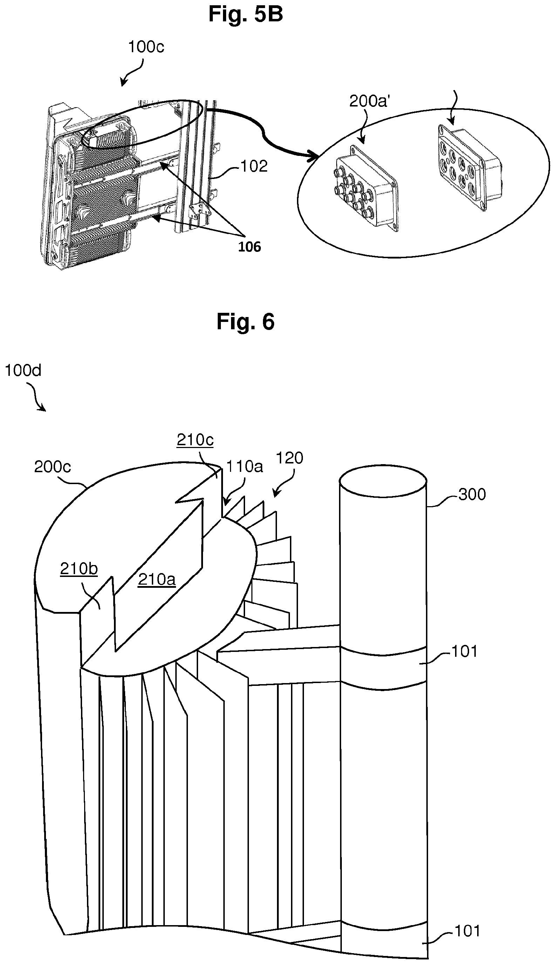

Figure 5B schematically depicts details of the blind mate RF connectors 200a', 200b', also cf. Fig. 4A, and of the sliding rails 106.

According to further exemplary embodiments, cf. the perspective view of the mounting device 100d of Fig. 6, said mounting surface 110a of the mounting device 100d is configured to form a dovetail joint 110a. Some (but not all) of the respective surface portions of a complementary contact surface 210 of the active module 200c are denoted with reference signs 210a, 210b, 210c. This configuration, too, enables an efficient transfer of thermal energy from the module 200c to the mounting device 100d, which may in turn transfer said heat energy to the surrounding air by means of its heatsink 120.

According to further exemplary embodiments, a mortise and tenon joint (not shown) may also be provided for said heat transfer surfaces 110, 210. According to further exemplary embodiments, other low mechanical tolerance fixture designs are also possible for providing said heat transfer surfaces 110, 210.

According to further exemplary embodiments, at least a part of said mounting surface 110 (Fig. 1B) has a surface roughness of 6.3 µm (micrometer) or less.

According to further exemplary embodiments, said mounting surface 110 has a thermal conductance of about 200 to about 300 W/m*K (watts per meter kelvin).

Further exemplary embodiments relate to a system 1000 (Fig. 1A) comprising a mounting device 100 according to the embodiments and at least one active electronic module 200, wherein said active electronic module 200 has a contact surface 210 (Fig. 1B) for attachment to said non-planar mounting surface 110 of said mounting device 100, wherein said contact surface 210 comprises a shape which is complementary to said non-planar mounting surface 110.

Further exemplary embodiments relate to a use of at least one mounting device 100, 100a, 100b, 100c, 100d according to the embodiments for a) mounting at least one active electronic module 200, 200a, 200b to a structure 300 and/or for b) cooling said at least one active electronic module 200, 200a, 200b, wherein preferably the mounting element advantageously enables simultaneous mounting and cooling of said at least one active electronic module.

Further exemplary embodiments relate to an active electronic module 200 (Fig. 1B) for use with a mounting device according to the embodiments, wherein said electronic module 200 comprises a non-planar contact surface 210 configured to make thermally conductive contact with said non-planar mounting surface 110 of said mounting device.

In the following, further exemplary embodiments, effects and advantages are disclosed.

According to further exemplary embodiments, a heat dissipation capability of active antenna modules 200 may be improved using the mounting device according to the embodiments.

According to further exemplary embodiments, a weight of active antenna modules 200 may be reduced, as they do not require own heatsink(s) or substantially smaller heatsink(s) when being attached to the mounting device according to the embodiments, whereby an installation in the field is simplified, as the overall weight - compared to conventional systems - of the system 1000 (Fig. 1A) may be evenly distributed over the individual (and individually handleable) components 100, 200.

According to further exemplary embodiments, the modules 200 may comprise or represent active antennas (AA) and/or active-passive antennas (APA), e.g. related to sub 6 GHz 5G massive MIMO technologies.

According to further exemplary embodiments, for AA integrating for instance massive MIMO antenna panels having 8 x 12 dual-polarized "3.5 GHz" radiating elements, the antenna panel dimensions may be in the range of about 45 cm (width) x 75 cm (length) x 5cm (depth). According to further exemplary embodiments, at the back of such radiating panels may be placed different layers of active, i.e. electronic / electric devices, that may lead to a thickness of about 5 cm to 10 cm. At the back of these electronic / electric layers a heatsink may be placed, but, according to further exemplary embodiments, said heatsink may also be replaced by a contact surface 210 for transfer of heat energy to a mounting module 100 (Fig. 1B) according to the embodiments.

According to further exemplary embodiments, the module 200 may also comprise or represent a remote radio head, RRH, and/or other active elements that represent sources of thermal energy.

The principle according to the embodiments facilitates installation of active modules in the field, e.g. comprising transporting such modules on site (for example to carry them up to a roof *via* a stairway to reach the antenna mast 300 (Fig. 1A)), and reduces effort for lifting them during installation, because (heavy) heatsinks are not required to be integrated into the module(s) according to further exemplary embodiments.

According to further exemplary embodiments, e.g. during an installation phase of the module 200 at the mounting device 100, heat transfer between those elements 200, 100 may be further improved by the use of "thermal paste" (e.g., a highly thermally conductive substance) placed within the module 200 and the mounting surface 110. E.g., in some embodiments, thermal paste may be applied to at least one of said surfaces 110, 210.

## Claims

1. Mounting device (100) for mounting at least one active electronic module (200) to a structure (300), wherein said mounting device (100) comprises a non-planar mounting surface (110) to which said electronic module (200) can be mounted, and at least one heatsink (120) configured to transfer thermal energy (TE) from said mounting device (100) to a surrounding medium (M).

2. Mounting device (100) according to claim 1, wherein said mounting surface (110) enables a transfer (A1) of thermal energy from said electronic module (200) to said mounting device (100).

3. Mounting device (100) according to at least one of the preceding claims, wherein said mounting surface (110; 110a) comprises corrugations (111; 111a).

4. Mounting device (100) according to claim 3, wherein at least some of said corrugations (111; 111a) have a cross-section which is at least partly polygonal, particularly trapezoidal, or sinusoidal.

5. Mounting device (100) according to at least one of the preceding claims, wherein said mounting surface (110) is configured to form at least one of: a) a dovetail joint (110a), and/or b) a mortise and tenon joint with a contact surface (210) of said electronic module (200) .

6. Mounting device (100) according to at least one of the preceding claims, wherein an actual surface of said mounting surface (110) is larger than a projection of said mounting surface (110) to any arbitrary virtual plane.

7. Mounting device (100) according to at least one of the preceding claims, wherein said mounting device (100) comprises a main body (102) and at least one mounting element (104) that comprises said mounting surface (110; 110a).

8. Mounting device (100) according to claim 7, wherein said at least one mounting element (104) is movably attached to said main body (102).

9. Mounting device (100) according to claim 8, wherein said mounting device (100) comprises at least one sliding rail (106) that connects said at least one mounting element (104) to said main body (102).

10. Mounting device (100) according to at least one of the preceding claims, wherein at least a part of said mounting surface (110) has a surface roughness of 6.3 µm or less.

11. Mounting device (100) according to at least one of the preceding claims, wherein said mounting surface (110) has a thermal conductance of about 200 to about 300 W/m*K.

12. System (1000) comprising a mounting device (100) according to at least one of the preceding claims and at least one active electronic module (200), wherein said active electronic module (200) has a contact surface (210) for attachment to said non-planar mounting surface (110) of said mounting device (100), wherein said contact surface (210) comprises a shape which is complementary to said non-planar mounting surface (110).

13. Use of at least one mounting device (100) according to at least one of the claims 1 to 11 for a) mounting at least one active electronic module (200) to a structure (300) and/or for b) cooling said at least one active electronic module (200).

14. Active electronic module (200) for use with a mounting device (100) according to at least one of the claims 1 to 11, wherein said electronic module (200) comprises a non-planar contact surface (210) configured to make thermally conductive contact with said non-planar mounting surface (110) of said mounting device (100).
